Europäisches Patentamt

(19) European Patent Office

Office européen des brevets

(11) Veröffentlichungsnummer: **0 186 068**

**A1**

(12) **EUROPÄISCHE PATENTANMELDUNG**

(21) Anmeldenummer: 85115915.2

(22) Anmeldetag: 13.12.85

(51) Int. Cl.⁴: **H 04 J 1/06**

(30) Priorität: 19.12.84 HU 471884

(43) Veröffentlichungstag der Anmeldung:
02.07.86 Patentblatt 86/27

(84) Benannte Vertragsstaaten:
AT DE FR GB SE

(71) Anmelder: TELEFONGYAR
Hungária körut 126-132
H-1143 Budapest(HU)

(72) Erfinder: Bako, István
Fráter Loránd utca 57
H-1185 Budapest(HU)

(72) Erfinder: Füzy, Vilmos
Várfok utca 2/b
H-1012 Budapest(HU)

(72) Erfinder: Molnár, György
Sólyom László utca 23
H-1025 Budapest(HU)

(72) Erfinder: Nyéki, István
Gizella utca 32
H-1043 Budapest(HU)

(72) Erfinder: Szabo, Ilona
Oltvány utca 2177/1
H-1112 Budapest(HU)

(72) Erfinder: Tarján, Mária
Baross utca 117
H-1083 Budapest(HU)

(74) Vertreter: Patentanwälte Viering & Jentschura
Steinsdorfstrasse 6
D-8000 München 22(DE)

(54) Schaltungsanordnung zur Erzeugung von Kanalträgerfrequenzen, Pilothilfsfrequenzen, Systemträgerfrequenzen und Systemträger-Steuerfrequenzen für vielkanälige Trägerstrom-Fernsprechanlagen mit Vormodulationssystem.

(57) Die Erfindung betrifft eine Schaltungsanordnung zur Erzeugung von Kanalträgerfrequenzen und Pilothilfsfrequenzen für vielkanälige Trägerstrom-Fernsprechanlagen mit Vormodulationssystem, die mit einem Grundoszillator, einer sich dem Ausgang des Grundoszillators anschliessenden Kombination von Frequenzteilern, an den Ausgang der Frequenzteiler angeschlossenen Verstärkern, oder an den Ausgang der Frequenzteiler angeschlossenem Filter, desweiteren an den Ausgang der Verstärker angeschlossenen Modulatoren oder an den Filtern angeschlossenem Modulator und an den Ausgang der Modulatoren angeschlossenen Filtern sowie Kanalfrequenzträgerausgängen versehen ist.

Das Wesen der erfindungsgemässen Schaltungsanordnung besteht darin, dass an den einzigen Grundoszillator (0) mindestens zwei Frequenzteiler (D1-D10) unmittelbar angeschlossen sind, desweiteren von den Frequenzausgängen der Schaltungsanordnung mindestens fünf Frequenzausgänge ($P_{S1}$, $F_{C2}$ $F_{C6}$, $F_{C10}$, $F_e$) unmittelbar oder über einen Verstärker (E1, E2, E3, E4) an je einen Frequenzteiler (D3, D2, D4, D6, D5, D7, D8) angeschlossen sind.

Die Erfindung betrifft weiterhin eine Schaltungsanordnung zur Erzeugung von Kanalträgerfrequenzen, Pilothilfsfrequenzen und Systemträger-Steuerfrequenzen für vielkanälige Trägerstrom-Fernsprechenanlagen mit Vormodulationssystem, bei der der Grundoszillator an mindestens zwei Frequenzteiler (D1, D11) unmittelbar angeschlossen ist, desweiteren von siebzehn Frequenzausgängen mindestens sieben Frequenzausgänge ($F_E$, $F_{C2}$, $F_{C4}$, $F_{C6}$, $F_{C10}$, $F_{V2}$, $P_{S1}$) unmittelbar oder über einen Verstärker (E1, E2, E3, E6) gegebenenfalls über einen Filter (SZ12) an die Frequenzteilers (D3, D2, D4, D13, D7, D8, D16) angeschlossen sind.

Die erfindungsgemässe Schaltungsanordnung zur Erzeugung von Kanalträgerfrequenzen, Systemträger-Steuerfrequenzen und Systemträgerfrequenzen für vielkanälige Trägerstrom-Fernsprechanlagen derart ausgebildet, dass an den einzigen Oszillator (0) mindestens zwei Frequenzteiler (D1, D11) unmittelbar angeschlossen sind, desweiteren von fünfzehn Frequenzausgängen mindestens sechs Frequenzausgänge ($F_e$, $F_{C2}$, $F_{C4}$, $F_{C6}$, $F_{C10}$, $F_{V1}$) unmittelbar oder über einen Verstärker an den Ausgang der Fre-

./...

EP 0 186 068 A1

quenzteiler (D3, D7, D13, D4, D2, D14) angeschlossen sind.
Die Ausführung der erfindungsgemässen Schaltungsanordnung, die zur Erzeugung von Kanalträgerfrequenzen und Systemträger-Steuerfrequenzen für vielkanälige Trägerstrom-Fernsprechanlagen dient, ist derart ausgebildet, dass an den einzigen Grundoszillator (0) mindestens zwei Frequenzteiler (D1, D11) unmittelbar angeschlossen sind, desweiteren von sieben Frequenzausgängen mindestens sechs Frequenzausgänge ($F_e$, $F_{C4}$, $F_{C6}$, $F_{V1}$, $F_{V2}$, $F_{V3}$) über einen Verstärker (E1) oder Filter (SZ12) an den Ausgang des Frequenzteilers angeschlossen sind.

Fig. 4

I

Schaltungsanordnung zur Erzeugung von Kanalträgerfrequenzen, Pilothilfsfrequenzen, Systemträgerfrequenzen und Systemträger-Steuerfrequenzen für
vielkanälige Trägerstrom-Fernsprechenanlagen mit
Vormodulationssystem

Die Erfindung betrifft eine Schaltungsanordnung zur
Erzeugung von Kanalträgerfrequenzen, Pilothilfsfrequenzen,
Systemträgerfrequenzen und Systemträger-Steuerfrequenzen
für vielkanälige Trägerstrom-Fernsprechanlagen mit Vormodulationssystem.

Die Kanalmodulationskaskaden beanspruchen - wie bekannt - eine grösse Anzahl von Trägerfrequenzen mit hoher
Signalreinheit und grosser Genauigkeit. Zur Ausbildung
einer 12-kanäligen Grundgruppe sind gemeinsam mit der Vormodulationsträgerfrequenz dreizehn verschiedene Trägerfrequenzen erforderlich.

Wie bekannt ist die Modulation bei der Ausbildung
der Grundgruppe mit Vormodulationssystem zweistufig. Zuerst werden alle Kanäle mit der Vormodulationsträgerfrequenz moduliert, danach wird das eine Seitenband mittels
eines Kanalfilters ausgefiltert danach entsteht durch Modulation der Seitenbänder eines jeden Kanals mit jeweils
verschiedenen Kanalträgerfrequenzen die den Empfehlungen
des CCITT entsprechende 12-kanälige Grundgruppe, die einen

0186068

Bereich von 60 bis 108 kHz umfasst. Das bei der zweiten Modulation entstehende überflüssige Seitenband wird mittels eines Gruppenfilters abgeschnitten. Die Grundgruppe besitzt eine umgekehrte Lage, das bedeutet, dass die Nullfrequenz des ersten Kanals auf 108 kHz fällt, während die Nullfrequenz der übrigen Kanäle ordnungsgemäss auf 104, 100...64 kHz fällt. Mit anderen Worten, die grösste Kanalträgerfrequenz gehört zum 1. Kanal der Grundgruppe.

In den Anlagen ist das mit grösster Anzahl vorkommende Element die Kanaleinheit mit dem sendungs- und empfangsgerichteten Kanalbandfilter.

Bei den Anlagen mit Vormodulationssystem kann jeder Kanalbandfilter gleich ausgebildet sein, demzufolge können auch die Kanaleinheiten gleich ausgebildet sein. Dieser Umstand hat eine bedeutende ökonomische Auswirkung, da dadurch die Kanaleinheiten der Systeme mit kleiner und grosser Anzahl von Kanälen gleicherweise ausgebildet sein können, die Produktionsstückzahl erhöht sich, die Instandhaltung wird einfacher, usw.

Der Preis der einheitlichen preisgünstigen Kanaleinheiten, die relativ komplizierterte Trägererzeugung, sind jedoch auch so noch viel wirtschaftlicher bei dem Vormodulationssystem als bei der Vorgruppe oder bei dem unmittelbaren Modulationssystem.

Wie bekannt bestehen die Schaltungen zur Erzeugung der Trägerfrequenzen für Trägerstromanlagen aus hochstabilen Oszillatoren, Frequenzvervielfachern (harmonischen Generatoren), Frequenzteilern, Modulatoren, Filtern und Verstärkern.

Diese Schaltungen sind nicht gleicherweise zu den modernen Montagetechnologien verwendbar. Am einfachsten sind die Frequenzteiler verwendbar und diese sind auch am preisgünstigsten. Die Herstellung der Thermostate und Filter ist kompliziert, zeitaufwendig und kostenaufwendig. Deswegen besteht bei den modernen Vorrichtungen das Be-

- 3 -                                      0186068

streben, die Anzahl der Thermostate und Filter zu verringern, bzw. in erster Linie die sonstigen integrierbaren Elemente, z.B. Frequenzteiler, Verstärker zu verwenden.

Im Weiteren werden der bekannten und der erfindungsgemässen Schaltungsanordnung, die im Folgenden miteinander verglichen werden, die am Ende der Ketten befindlichen Verstärker nicht als Systemmerkmal betrachtet und
von ihrer Darstellung wird abgesehen.

Die zu erzeugenden Frequenzen sind – infolge der 4
kHz-Kanalteilung – das Vielfache von 4 kHz. Eine Ausnahme
stellt die einzige Systemträgerfrequenz dar, die unmittelbar ausgehend von 4 kHz nicht erzeugt werden kann.

Das Wesen der allgemein verwendeten Schaltungsanordnung zur Erzeugung der Vielfachen von 4 kHz besteht darin,
dass über einem Bandfilter, das an den Ausgang eines die
geradzahligen und ungeradzahligen Harmonischen von 4 kHz
erzeugenden harmonischen Generators angeschlossen ist, die
erforderlichen Frequenzen ausgewählt werden. Die ausgewählten Frequenzen sind zu verstärkern. Diese Lösung hat
allgemein bekannt den Nachteil, dass eine grosse Anzahl
von Bandfiltern mit strengen Parametern erforderlich ist,
wodurch die Fertigung kompliziert wird und einen grossen
Kostenaufwand zur Folge hat.

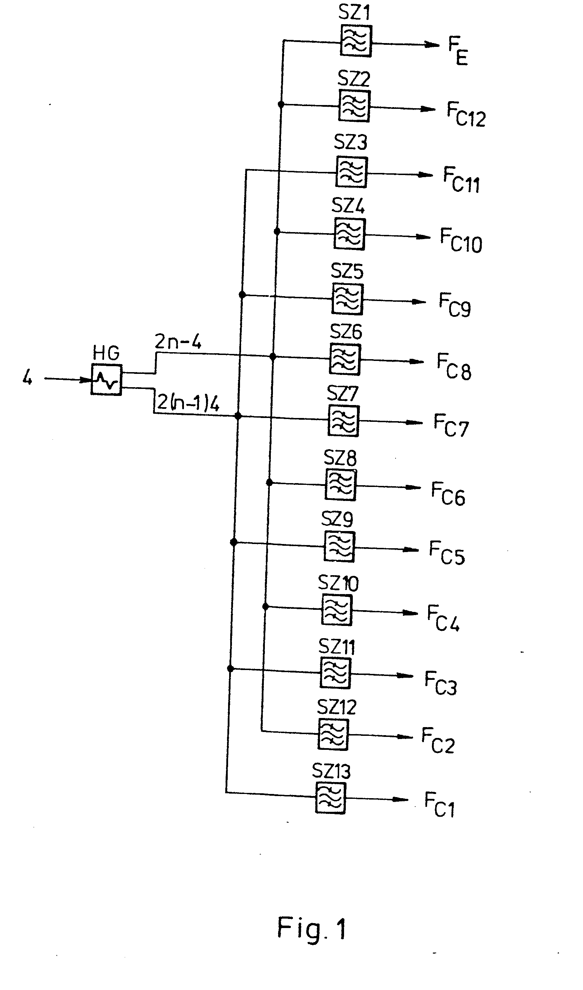

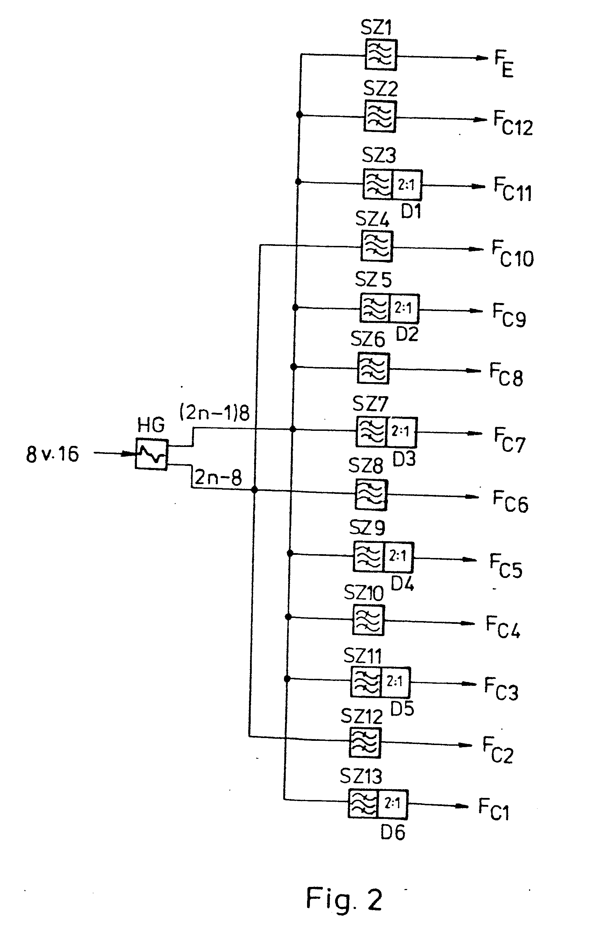

Das Wesen der ebenfalls bekannten, in Fig. 2 dargestellten Lösung besteht ähnlich zu der in Fig. 1 dargestellten darin, dass diese ebenfalls mit sich dem harmonischen Generator anschliessenden Filtern ausgebildet ist.
Der Unterschied dieser Lösung zu der in Fig. 1 dargestellten besteht darin, dass die Steuerfrequenz ein Vielfaches
von 4 kHz beträgt, sodass die Störkomponenten im Ausgangsspektrum weiterentfernt liegen. Dadurch wird es ermöglicht,
die Anzahl der Filterelemente zu verringern.

Sowohl bei der in Fig. 1 dargestellten als auch bei
der in Fig. 2 dargestellten Schaltungsanordnung wird durch die Trennung des Ausganges der geradzahligen Harmonischen und der ungeradzahligen Harmonischen eine Einsparung von Filterelementen erreicht.

Ein Nachteil der in Fig. 2 dargestellten Schaltungsanordnung besteht jedoch darin, dass von bestimmten Frequenzen nur das Zweifache im Spektrum vorkommt, so dass zur Erzeugung dieser Frequenzen eine nachträgliche Frequenzteilung erforderlich ist. Bei beiden bisherigen Schaltungsanordnungen kann ein Havariefall nur durch einen Fehler des Oszillators oder des harmonischen Generators hervorgerufen werden. Ein Fehler der am Ende der Ketten befindlichen Filter (oder der nicht dargestellten Verstärker) führt nur zu einem teilweisen Betriebsausfall, die fehlerhaften Schaltungsteile sind ohne Einfluss auf die Funktion der übrigen Teile entfernbar. Das System ist "radial".

Es gibt weiterhin eine Lösung, bei der die erforderlichen Frequenzen mittels PLL-Schaltungen (Phasensynchronisierungsschleife) erzeugt werden. Dieses System ist ebenfalls Frequenzsteif. Die Genauigkeit der Ausgangsfrequenzen hängt von der Genauigkeit der Steuerfrequenz ab, das ist ein Vorteil das Systems. Ein Nachteil dieses Systems besteht darin, dass zur Erzeugung einer jeden Frequenz je eine PLL-Schaltung erforderlich ist, bei denen die spannungsgesteuerten Oszillatoren VCO infolge ihrer Varicap-Stimmbarkeit bei einer Frequenz von 5...10 MHz arbeiten müssen. Wegen der Gefahr des Nebensprechens ist dies nur in getrennten, abgeschirmten Schaltungseinheiten realisierbar. Die Ausgangsfrequenzen werden nach einer Frequenzteilung erhalten. Bei den PLL-Schaltungen ist dafür zu sorgen, dass bei Ausbleiben der Steuerfrequenz aus dem dann freilaufenden spannungsgesteuerten Oszillator VCO keine fehlerhafte Frequenz ausgegeben wird.

Das Ziel der Erfindung besteht in der Beseitigung der obenerwähnten Nachteile.

Die Erfindung beruht auf der Erkenntnis, dass die einfachste und wirtschaftlichste Lösung darin besteht, jede Frequenz aus dem Signal eines einzigen Oszillators abzuleiten. Dann ist die Frequenz des Oszillators das kleinste gemeinsame Vielfach der erforderlichen Frequenzen. Infolge der grossen Anzahl der Frequenzen würde sich jedoch dabei eine unrealisierbar grosse Frequenz ergeben. Um dies zu vermeiden wird ein Kompromis vorgeschlagen, dass eine solche Oszillatorfrequenz gewählt wird, aus der mindestens ein Teil der erforderlichen Frequenzen durch ganzzahlige Teilung gewonnen werden kann und aus den bereits geteilten Frequenzen und durch weitere Teilung gewonnenen Frequenzen die noch fehlenden Frequenzen durch Modulation derart erzeugt werden, dass dabei die Anzahl der verwendeten Modulatoren und Filter minimal bleibt.

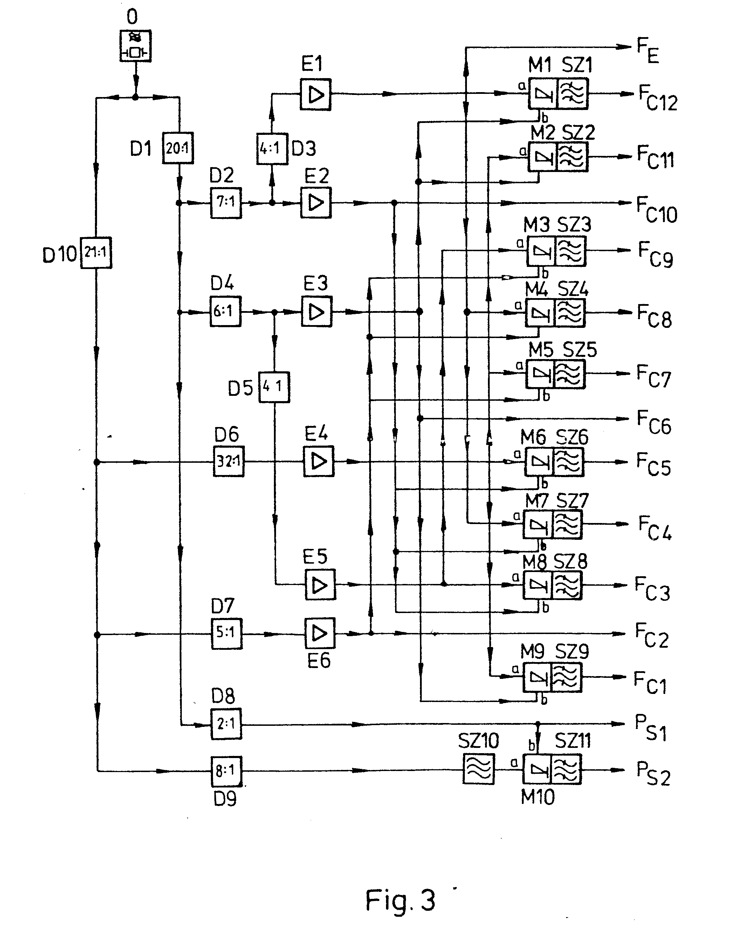

Die Schaltungsanordnungen in den Fig. 3, 4, 5 und 6 zeigen Lösungen, die auf der obigen Erkenntnis beruhen.

Die erfindungsgemässe Schaltungsanordnung bietet eine Lösung zur einheitlichen Trägerfrequenzerzeugung für ein einheitliches Kanalmodulationssystem. Die gemäss der Erfindung ausbildbaren Schaltungsanordnungen sind solche Varianten der erfindungsgemässen Basisanordnung, die in Abhängigkeit von der Anzahl der Kanäle, oder in Abhängigkeit von dem Anspruch an die Steuerfrequenz des entsprechenden Freileitungs- oder Kabelsystems unterschiedlich ausgebildet sein können (Fig. 3, 4, 5, 6). Von den sonstigen Frequenzen, die zur Funktion der mit der erfindungsgemässen Schaltungsanordnung versehenen Anlagen erforderlich sind, bezieht sich die Erfindung auf die Erzeugung einer Systemträgerfrequenz, von zwei zum Pilotempfang erforderlichen Pilothilfsfrequenzen, sowie von einigen Systemträger-Steuerfrequenzen.

Von Vorteil ist, dass die geteilten Frequenzen theoretisch nur ihre eigenen Harmonischen beinhalten können und andere fremde Frequenzen nicht, und sind deshalb nach der Sinusformung unmittelbar verwendbar. Die vormodulierende Kanalträgerfrequenz $F_E$ ist z.B. auf 24 kHz wählbar.

Die erfindungsgemässe Schaltungsanordnung verfügt über die Vorteile der früheren bekannten Schaltungsanordnungen, und zwar die Steuerung mit einem einzigen Oszillator, die "radiale" Anordnung.

Ein weiterer Vorteil der Erfindung besteht darin, dass die Filter einfach sind, da sie nur die in der Frequenz entfernt liegende, nicht versendete Seitenfrequenz und den Trägerleckstrom zu unterdrücken haben. Die Modulatoren können mit den Filtern zusammengebaut werden. Bei den Schaltungsanordnungen kann ein beliebiger Modulator oder Ausgang weggelassen werden - entsprechend dem aktuellen Aufbau - ohne die Störung der Funktion der sonstigen Schaltungsteile.

In den erfindungsgemässen Schaltungsanordnungen wird eine geringe Anzahl von Hilfsfrequenzen auch zugelassen, die das System nicht verlassen, jedoch zur Erzeugung der Ausgangsfrequenzen vorteilhaft erforderlich sind.

Die Erfindung wird nachstehend anhand von bevorzugten Ausführungsbeispielen mit Bezugnahme auf die beigefügte Zeichnung näher erlautert.

Es zeigen:

Fig. 1    eine ansich bekannte Schaltungsanordnung, die mit einem harmonischen Generator zur Erzeugung der Vielfachen von 4 kHz und Bandfiltern versehen ist,

Fig. 2    eine weiterentwickelte Variante der Schaltungsanordnung gemäss Fig. 1,

Fig. 3    ein Blockschema der erfindungsgemässen Schaltungsanordnung die die einem Vielfachen von 4 kHz entsprechenden Frequenzen ausschliesslich durch Frequenzteilung und Modulation erzeugt,

Fig. 4    eine weiterentwickelte Ausführungsform der erfindungsgemässen Schaltungsanordnung gemäss Fig. 3, bei der ähnlicherweise die Vielfachen der Frequenz von 4 kHz durch Frequenzteilung und durch Modulation erzeugt werden, sowie weiterhin weitere zwei Steuerfrequenzen erzeugt werden,

Fig. 5    eine weiterentwickelte Ausführungsform der Schaltungsanordnung gemäss Fig. 4, die davon abweichend zwei Signale, d.h. eine Steuerfrequenz und ein Pilotsignal erzeugt,

Fig. 6    eine vereinfachte Variante der Schaltungsanordnung gemäss Fig. 4, wobei alle Frequenzen entweder durch Teilung oder durch Teilung und Modulation erzeugt werden.

Der Umstand, dass die meisten der Frequenzen ein Vielfaches von 4 kHz darstellen, macht die Verwendung eines frequenzvervielfachenden harmonischen Generators und die Auswahl der erforderlichen Frequenzen mittels Filter naheliegend. Eine derartige Schaltungsanordnung ist in Fig. 1 dargestellt. An einen in erster Linie geradzahlige Harmonische beinhaltenden 2n · 4 kHz geraden Ausgang eines harmonischen Generators HG sind Filter SZ1, SZ2, ...SZ12 angeschlossen, während sich dem ungeraden Ausgang (2n-1) · 4 kHz des harmonischen Generators HG Filter SZ3...SZ13 anschliessen. Vorteil dieser bekannten Lösung ist, dass die erforderliche Frequenzgenauigkeit und Stabilität infolge des einzigen Oszillators leicht zu sichern sind. Der Nachteil dieser Lösung besteht darin, dass zur entsprechend reinen Erzeugung der dreizehn Frequenzen dreizehn komplizierte Filter erforderlich sind, trotz der Trennung von geraden und ungeraden Ausgängen des harmonischen Generators. Die Filter dürfen das Spektrum auf der Frequenz der übrigen Filter nicht belasten, d.h. sie müssen parallel schaltbar sein. Die in Fig. 2 dargestellte bekannte Lösung ist eine verbesserte Ausführung. Bei dieser Schaltungsanordnung wird von einem zweifachen, 8 kHz-Spektrum des harmonischen Generators - infolge der Vereinfachung der Filter - ausgegangen. Infolgedessen gibt es solche Frequenzen, von denen nur das Zweifache im Spektrum vorkommt, deswegen ist nach Ausfiltern der Frequenzen noch eine 2:1 Frequenzteilung erforderlich (in der Fig. bei den Frequenzen $F_{C1}$, $F_{C3}$, $F_{C5}$, $F_{C7}$, $F_{C9}$ und $F_{C11}$). Bei dieser Lösung ist die Anzahl der Filter ebenfalls dreizehn.

Die erfindungsgemässe Schaltungsanordnung gemäss Fig. 3 dient zur Erzeugung von Kanalträgerfrequenzen und Pilothilfsfrequenzen für vielkanälige Trägerstrom-Fernsprechanlagen mit Vormodulationssystem. Ein Ausgang eines Grundoszillators O ist einerseits an den Eingang eines Frequenzteilers D1 mit einem Teilerverhältnis von 20:1 und andererseits an einen Eingang eines Frequenzteilers D10 mit einem Teilerverhältnis von 21:1 angeschlossen. Der Ausgang des Frequenzteilers D1 verzweigt sich in drei Richtungen, und zwar ist dieser mit dem Eingang eines Frequenzteilers D2 mit einem Teilerverhältnis von 7:1, mit dem Eingang eines Frequenzteilers D4 mit einem Teilerverhältnis von 6:1 und mit dem Eingang eines Frequenzteilers D8 mit einem Teilerverhältnis von 2:1 verbunden. Der Ausgang des Frequenzteilers D10 ist an den Eingang des Frequenzteilers D6 mit einem Teilerverhältnis von 32:1, an den Eingang des Frequenzteilers D7 mit einem Teilerverhältnis von 5:1 und an den Eingang des Frequenzteilers D9 mit einem Teilerverhältnis von 8:1 geführt. Der Ausgang des Frequenzteilers D2 ist mit dem Eingang eines Frequenzteilers D3 mit einem Teilerverhältnis von 4:1 und mit dem Eingang eines Verstärkers E2 verbunden. Der Ausgang des Frequenzteilers D4 ist mit dem Eingang eines Frequenzteilers D5 mit einem Teilerverhältnis von 4:1 und mit dem Eingang eines Verstärkers E3 verbunden. Der Ausgang des Frequenzteilers D6 ist an den Eingang eines Verstärkers E4 angelegt. Der Frequenzteiler D7 ist an den Eingang eines Verstärkers E6 angeschlossen. Der Ausgang des Frequenzteilers D8 ist mit einem Pilothilfsfrequenzausgang $P_{S1}$ und einem Eingang b eines Modulators M10 verbunden. Der Ausgang des Frequenzteilers D9 ist an den Eingang eines Filters SZ10 angeschlossen, dessen Ausgang mit einem Eingang a des Modulators

M10 verbunden ist. Ein Ausgang eines an den Ausgang des Modulators M10 angeschlossenen Filters SZ11 ist mit einem Pilothilfsfrequenzausgang $P_{S2}$ verbunden. Der Ausgang des Frequenzteilers D5 mit einen Teilerverhältnis von 4:1 ist an einem Eingang eines Verstärkers E5 geführt. Der Ausgang des Frequenzteilers D3 mit einem Teilerverhältnis von 4:1 dagegen ist mit dem Eingang eines Verstärkers E1 verbunden. Der Ausgang des Verstärkers E1 verzweigt sich in vier Richtungen: an einen Vormodulationsträgerfrequenausgang $F_E$, an einen Eingang a eines Modulators M1, an einen Eingang a des Modulators M4 und an einen Eingang a des Modulators M7. Der Ausgang des Verstärkers E2 verzweigt sich ebenfalls in vier Richtungen: an einen Kanalträgerfrequenzausgang $F_{C10}$, an einen Eingang b eines Modulators M6, an einen Eingang b eines Modulators M7 und an einen Eingang b eines Modulators M8. Der Ausgang des Verstärkers E3 verzweigt sich auch in vier Richtungen: an einen Eingang b des Modulators M1, einen Eingang b des Modulators M2, einen Kanalträgerfrequenzausgang $F_{C6}$ und einen Eingang b des Modulators M9. Der Ausgang des Verstärkers E4 ist ebenfalls in vier Richtungen verzweigt: an einen Eingang a eines Modulators M2, an einen Eingang a eines Modulators M5, an einen Eingang a eines Modulators M6 und an einen Eingang a eines Modulators M9. Der Ausgang des Verstärkers E5 verzweigt sich in zwei Richtungen: an einen Eingang a des Modulators M3 und an einen Eingang a des Modulators M8. Der Ausgang des Verstärkers E6 verzweigt sich in vier Richtungen: an den Eingang b des Modulators M3, einen Eingang b des Modulators M4, einen Eingang be des Modulators M5 und einen Kanalträgerfrequenzausgang $F_{C2}$. Ein Ausgang eines sich dem Modulator M1 anschliessenden Filters SZI ist ein Kanalträgerfrequenzausgang $F_{C12}$, ein Ausgang eines sich dem Modulator M2 anschliessenden Filters SZ2 ist ein Kanalträgerfrequenzausgang $F_{C11}$, ein Ausgang eines sich dem Modulator M3 anschliessenden Filters SZ3 ist ein Kanalträgerfrequenzausgang $F_{C9}$, ein Ausgang eines sich dem Modulator M4 anschliessenden Filters SZ4 ist ein Kanalträgerfrequenzausgang $F_{C8}$, ein Ausgang eines sich dem Modulator M5 anschliessenden Filters SZ5 ist ein Kanalträgerfrequenzausgang $F_{C7}$, ein Ausgang eines sich dem Modulator M6 anschliessenden Filters SZ6 ist ein Kanalträgerfrequenzausgang $F_{C5}$, ein Ausgang eines sich dem Modulator M7 anschliessenden Filters SZ7 ist ein Kanalträgerfrequenzausgang $F_{C4}$, ein Ausgang eines sich dem Modulator M8 anschliessenden Filters SZ8 ist ein Kanalträgerfrequenzausgang $F_{C3}$, während ein Ausgang eines sich dem Modulator M9 anschliessenden Filters SZ9 einen Kanaltragerfrequenzausgang $F_{C1}$ darstellt.

Die Anzahl der in der Schaltungsanordnung gemäss Fig. 3 verwendeten charakteristischen Bauelemente wird nachstehend zusammengefasst:

| | |
|---|---|
| Oszillator | 1 |
| Frequenzvervielfacher oder harmonischer Generator | 0 |
| Frequenzteiler | 10 |
| Modulator – Filter | 10 |
| Filter | 0 |
| Verstärker (innerhalb der Kette) | 6 |
| Anzahl der Ausgangsfrequenzen | 15 |

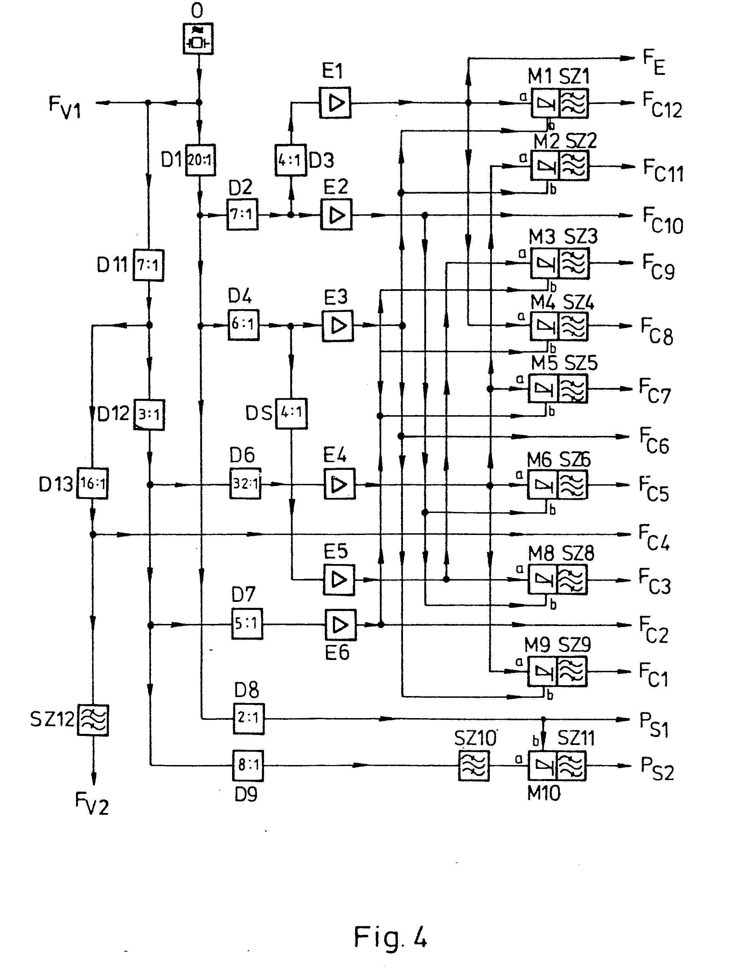

Fig. 4 veranschaulicht eine erfingunsgemässe Schaltungsanordnung zur Erzeugung von Kanalträgerfrequenzen, Pilothilfsfrequenzen und Systemträger-Steuerfrequenzen für vielkanälige Trägerstrom-Fernsprechanlagen mit Vormodulationssystem.

Der Ausgang des Grundoszillators 0 ist in drei Richtungen verzweigt: an einen Systemträger-Steuerfrequenzausgang $F_{V1}$, an einen Eingang eines Frequenzteilers D1 mit einem Teilerverhältnis von 20:1, und an einen Eingang eines Frequenzteilers D11 mit einem Teilerverhältnis von 7:1. Der Ausgang des Frequenzteilers D1 mit einem Teilerverhältnis von 20:1 verzweigt sich in drei Richtungen: an den Eingang des Frequenzteilers D2 mit einem Teilerverhältnis von 7:1, an den Eingang des Frequenzteilers D4 mit einem Teilerverhältnis von 6:1 und an den Eingang des Frequenzteilers D8 mit einem Teilerverhältnis von 2:1. Der Ausgang des Frequenzteilers D11 mit einem Teilerverhältnis von 7:1 verzweigt sich in zwei Richtungen: an einen Eingang eines Frequenzteilers D12 mit einem Teilerverhältnis von 3:1 und an einen Eingang eines Frequenzteilers D13 mit einem Teilerverhältnis von 16:1. Der Ausgang des Frequenzteilers D12 mit einem Teilerverhältnis von 3:1 verzweigt sich in drei Richtungen: an den Eingang des Frequenzteilers D6 mit einem Teilerverhältnis von 32:1, an den Eingang des Frequenzteilers D7 mit einem Teilerverhältnis von 5:1 und an den Eingang des Frequenzteilers D9 mit einem Teilerverhältnis von 8:1. Der Ausgang des Frequenzteilers D13 mit einem Teilerverhältnis von 16:1 ist an einen Kanalträgerfrequenzausgang $F_{C4}$ und an einen Eingang eines Filters SZ12 angeschlossen. Der Ausgang des Filters SZ12 stellt einen Kanalträger-Steuerfrequenzausgang $F_{V2}$ dar. Der Ausgang des Frequenzteilers D2 mit einem Teilerverhältnis von 7:1 ist mit dem Eingang des Verstärkers E2 und dem Eingang des Frequenzteilers D3 mit einem Teilerverhältnis von 4:1 verbunden. Der Ausgang des Frequenzteilers D3 mit einem Teilerverhältnis von 4:1 ist an den Eingang des Verstärkers E1 angeschlossen. Der Ausgang des Frequenzteilers D4 mit einem Teilerverhältnis von 6:1 ist mit dem Eingang des Verstärkers E3 und dem Eingang des Frequenzteilers D5 mit einem Teilerverhältnis von 4:1 verbunden. Der Ausgang des Frequenzteilers D5 mit einem Teilerverhältnis von 4:1 ist an den Eingang des Verstärkers E5 angelegt, während der Ausgang des Frequenzteilers D6 mit einem Teilerverhältnis von 32:1 mit dem Eingang des Verstärkers E4 verbunden ist. Der Ausgang des Frequenzteilers D7 mit einem Teilerverhältnis von 5:1 ist an den Eingang des Verstärkers E6 angeschlossen. Der Ausgang des Frequenzteilers D8 mit einem Teilerverhältnis von 2:1 ist an einen Pilothilfsfrequenzausgang $P_{S1}$ und an einen Eingang b des Modulators M10 geführt. Der Ausgang des Verstärkers E1 verzweigt sich in drei Richtungen: an einen Vormodulationsträgerfrequenzausgang $F_E$, an den Eingang des Modulators M1 und an den Eingang des Modulators M4. Der Ausgang des Verstärkers E2 verzweigt sich in drei Richtungen: an einen Kanalträgerfrequenzausgang $F_{C10}$ an den Eingang des Modulators M6 und an den Eingang des Modulators M8. Der Ausgang des Verstärkers E3 verzweigt sich in vier Richtungen: an einen Eingang b eines Modulators M1 und des Modulators M2, an einen Kanalträgerfrequenzausgang $F_{C6}$ und an den Eingang b des Modulators M9. Der Ausgang des Verstärkers E4 verzweigt sich in vier Richtungen: an den Eingang der Modulatoren M2, M5, M6 und M9. Der Ausgang des Verstärkers E5 ist mit dem Eingang der Modulatoren M3 und M8 verbunden. Der Verstärker E6 ist mit seinem Ausgang an den Eingang b der Modulatoren M3, M4 und M5 und an einen Kanalträgerfrequenzausgang $F_{C2}$ angeschlossen.

Der Ausgang des Frequenzteilers D9 mit einem Teilerverhältnis von 8:1 ist an den Eingang des Filters SZ10 angeschlossen, dessen Ausgang an den Eingang a des Modulators M10 angeschlossen ist. Der Ausgang eines sich dem Modulator M10 anschliessenden Filters SZ11 bildet einen Pilothilfsfrequenzausgang $P_{S2}$. Der Ausgang des an den Modulator M1 angeschlossenen Filters SZ1 bildet einen Kanalträgerfrequenzausgang $F_{C12}$. Der Ausgang des sich dem Modulator M2 anschliessenden Filters SZ2 bildet den Kanalträgerfrequenzausgang $F_{C11}$. Der Ausgang des an den Modulator M3 angeschlossenen Filters SZ3 bildet den Kanalträgerfrequenzausgang $F_{C9}$. Der Ausgang des mit dem Modulator M4 verbundenen Filters SZ4 bildet den Kanalträgerfrequenzausgang $F_{C8}$. Der Ausgang des an den Modulator M5 angeschlossenen Filters SZ5 bildet den Kanalträgerfrequenzausgang $F_{C7}$. Der Ausgang des an den Modulator M6 angeschlossenen Filters SZ6 bildet den Kanalträgerfrequenzausgang $F_{C5}$. Der mit dem

Modulator M8 verbundene Filter SZ8 bildet den Kanalträgerfrequenzausgang $F_{C3}$. Der Ausgang des an den Modulator M9
angeschlossenen Filters Sz9 dagegen bildet den Kanalträgerfrequenzausgang $F_{C1}$.

Nachstehend wird ein Überblick über die Anzahl der
in der erfindungsgemässen Schlatungsanordnung gemäss Fig.
4 verwendeten charakteristischen Bauelemente gegeben:

| | |
|---|---|
| Oszillator | 1 |
| Frequenzvervielfacher oder harmonischer Generator | 0 |
| Frequenzteiler | 12 |
| Modulator - Filter | 10 |
| Filter | 1 |
| Verstärker (innerhalb der Kette) | 6 |

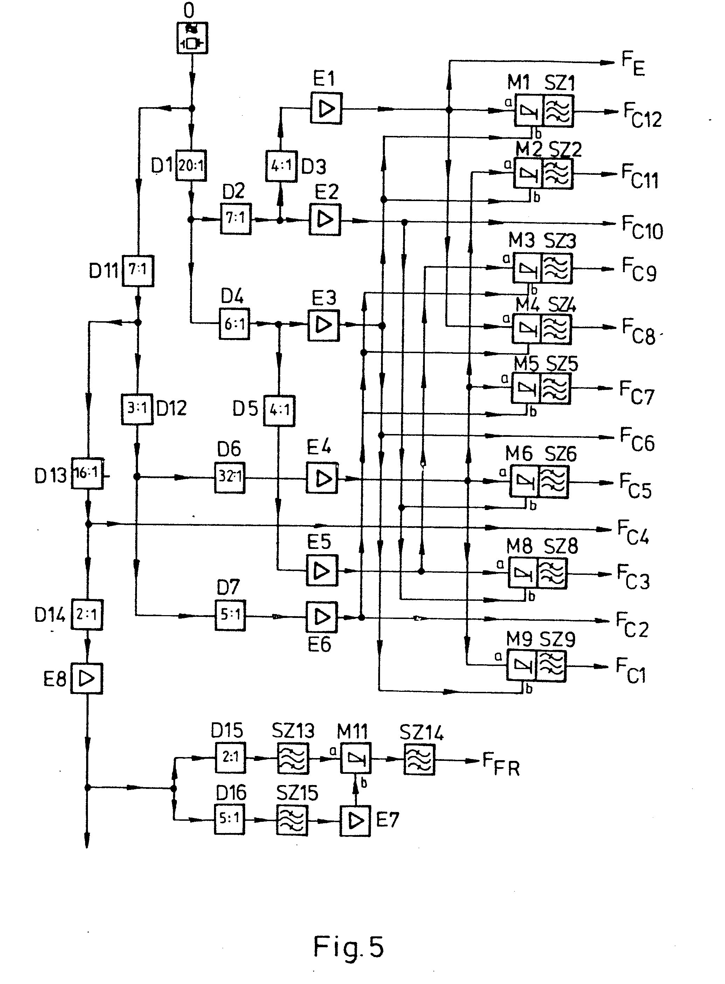

In Fig. 5 ist eine erfindungsgemässe Schaltungsanordnung zur Erzeugung von Kanalträgerfrequenzen, Systemträger-
Steuerfrequenzen und Systemträgerfrequenzen für vielkanälige Trägerstrom-Fernsprechanlagen mit Vormodulationssystem
dargestellt. Der Ausgang des Grundoszillators O verzweigt
sich in zwei Richtungen: an den Eingang des Frequenzteilers
D1 mit einem Teilerverhältnis von 20:1 und an den Eingang
des Frequenzteilers D11 mit einem Teilerverhältnis von 7:1.
Der Ausgang des Frequenzteilers D1 mit einem Teilerverhältnis von 20:1 ist mit dem Aingang des Frequenzteilers D2 mit
einem Teilerverhältnis von 7:1 und dem Eingang des Frequenzteilers D4 mit einem Teilerverhältnis von 6:1 verbunden,
der Ausgang des Frequenzteilers D11 mit einem Teilerverhältnis von 7:1 ist an den Eingang des Frequenzteilers D12
mit einem Teilerverhältnis von 3:1 und an den Eingang des
Frequenzteilers D13 mit einem Teilerverhältnis von 16:1 geführt. Der Ausgang des Frequenzteilers D12 mit einem Teilerverhältnis von 3:1 ist mit dem Eingang des Frequenzteilers
D6 mit einem Teilerverhältnis von 32:1 und dem Eingang des
Frequenzteilers D7 mit einem Teilerverhältnis von 5:1 verbunden. Der Ausgang des Frequenzteilers D13 ist an den Kanaltägerfrequenzausgang $F_{C4}$ und an den Eingang des Frequenzteilers D14 mit einem Teilerverhältnis von 2:1 angeschlossen. Der Ausgang des Frequenzteilers D14 mit einem Teilerverhältnis von 2:1 ist mit dem Eingang des Verstärkers E8 verbunden, während der Ausgang des Verstärkers E8 an einen Systemträger-Steuerfrequenzausgang $F_{V1}$ und an die Eingänge der Frequenzteiler D15 mit einem Teilerverhältnis von 2:1 und D16 mit einem Teilerverhältnis von 5:1 geführt ist. Der Ausgang des Frequenzteilers D2 mit einem Teilerverhältnis von 7:1 ist mit dem Eingang des Frequenzteilers D3 mit einem Teilerverhältnis von 4:1 und dem Eingang des Verstärkers E2 verbunden, während der Ausgang des Frequenzteilers D3 mit einem Teilerverhältnis von 4:1 an den Eingang des Verstärkers E1 angeschlossen ist. Der Ausgang des Frequenzteilers D4 mit einem Teilerverhältnis von 6:1 ist mit dem Eingang des Frequenzteilers D5 mit einem Teilerverhältnis von 4:1 verbunden. Der Ausgang des Frequenzteilers D5 mit einem Teilerverhältnis von 4:1 ist an den Eingang des Verstärkers E5 geführt. Der Ausgang des Frequenzteilers D7 mit einem Teilerverhältnis von 5:1 ist an den Eingang des Verstärkers E6 angelegt. Der Ausgang des Frequenzteilers D15 mit einem Teilerverhältnis von 2:1 ist mit dem Eingang des Filters SZ13 verbunden, dessen Ausgang an den Eingang des Modulators M11 angeschlossen ist, während der Ausgang des Modulators M11 an den Filter SZ14 angelegt ist. Der Ausgang des Frequenzteilers D16 mit einem Teilerverhältnis von 5:1 ist mit dem Eingang des Filters SZ15 verbunden, dessen Ausgang an den Eingang des Verstärkers E7 angeschlossen ist. Der Ausgang des Verstärkers E7 ist mit dem Eingang b des Modulators M11 verbunden. Der Ausgang des Filters SZ14 stellt gleichzeitig einen Systemträgerausgang $F_{FR}$ dar. Der Ausgang des Verstärkers E1 ist an einen Vormodulationsträgerfrequenzausgang $F_{E}$, sowie an die Eingänge a der Modulatoren M1 und M4 geführt. Der Ausgang des Verstärkers E2 ist an den Kanalträgerfrequenzausgang $F_{C10}$ sowie an die Eingänge b der Modulatoren M6 und M8 angeschlossen. Der Ausgang des Verstärkers E3 ist mit dem Eingang b der Modulatoren M1, M2 und M9 sowie mit dem Kanalträgerfrequenzausgang $F_{C6}$ verbunden. Der Ausgang des Verstärkers E4 ist an die Eingänge b der Modulatoren M2, M5, M6 und M9 angelegt. Der Ausgang des Verstärkers E5 ist mit den Eingängen a der Modulatoren M3 und M8 verbunden. Der Ausgang des Verstärkers E6 ist mit den Eingängen b der Modulatoren M3, M4 und M5 sowie mit dem Kanalträgerfrequenzausgang $F_{C2}$ verbunden. Der Ausgang des sich dem Modulator M1 anschliessenden Filters SZ1 bildet den Kanalträgerfrequenzausgang $F_{C12}$, während der Ausgang des sich dem Modulator M2 anschliessenden Filters SZ2 den Kanalträgerfrequenzausgang $F_{C11}$, der Ausgang des sich dem Modulator M3 anschliessenden Filters SZ3 den Kanalträgerfrequenzausgang $F_{C9}$, der Ausgang des sich dem Modulator M4 anschliessenden Filters SZ4 den Kanalträgerfrequenzausgang $F_{C8}$, der Ausgang des sich dem Modulator M5 anschliessenden Filters SZ5 den Kanalfrequenzträgerausgang $F_{C7}$, der Ausgang des sich dem Modulator M6 anschliessenden Filters SZ6 den Kanalträgerfrequenzausgang $F_{C5}$, der Ausgang des sich dem Modulator M7 anschliessenden Filters SZ7 den Kanalträgerfrequenzausgang $F_{C3}$ und der Ausgang des sich dem Modulator M9 anschliessenden Filters SZ9 den Kanalträgerfrequenzausgang $F_{C1}$ bilden.

Nachstehend wird ein Überblick über die Anzahl der in der erfindungsgemässen Schaltungsanordnung gemäss Fig. 5 verwendeten charakteristischen Bauelemente gegeben:

| | |
|---|---|
| Oszillator | 1 |
| Frequenzvervielfacher oder harmonischer Generator | 0 |
| Frequenzteiler | 13 |
| Modulator - Filter | 9 |
| Verstärker (innerhalb der Kette) | 8 |
| Filter | 2 |
| Anzahl der Ausgangsfrequenzen | 15 |

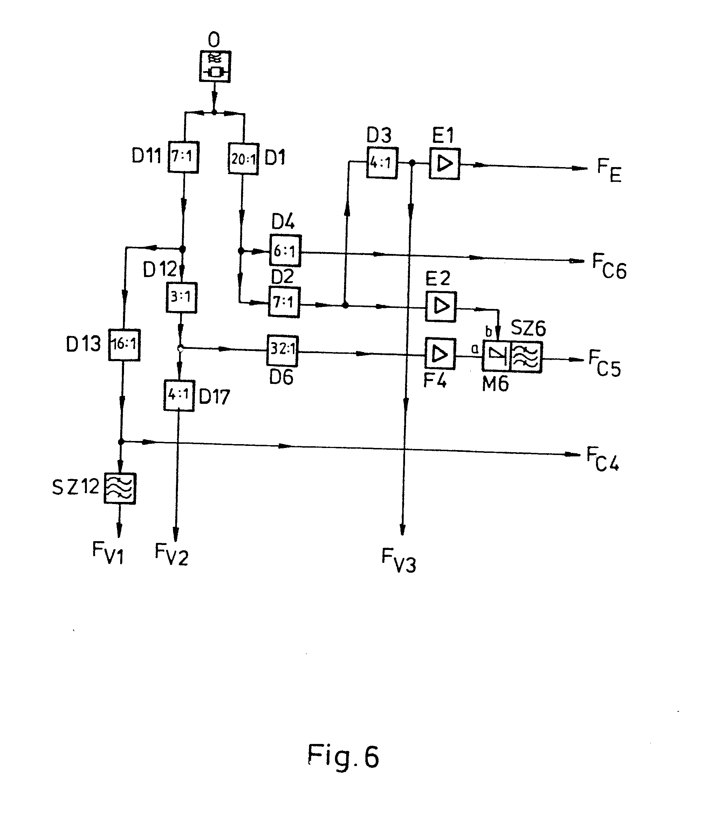

In Fig. 6 ist eine erfindungsgemässe Schaltungsanordnung zur Erzeugung von Kanalträgerfrequenzen und Systemträger-Steuerfrequenzen für Trägerstrom-Fernsprechanlagen mit Vormodulationssystem dargestellt. Der Ausgang des Grundoszillators O verzweigt sich in zwei Richtungen: an den Frequenzteiler D1 mit einem Teilerverhältnis von 20:1 und an den Frequenzteiler D11 mit einem Teilerverhältnis von 7:1. Der Ausgang des Frequenzteilers D1 mit einem Teilerverhältnis von 20:1 ist mit den Eingängen der Frequenzteiler D4 mit einem Teilerverhältnis von 6:1 und D2 mit einem Teilerverhältnis von 7:1 verbunden. Der Ausgang des Frequenzteilers D4 mit einem Teilerverhältnis von 6:1 bildet gleichzeitig den Kanalträgerfrequenzausgang $F_{C6}$. Der Ausgang des Frequenzteilers D2 mit einem Teilerverhältnis von 7:1 ist mit dem Eingang des Verstärkers E2 und dem Eingang des des Frequenzteilers D3 mit einem Teilerverhältnis von 4:1 verbunden. Der Ausgang des Frequenzteilers D3 mit einem Teilerverhältnis von 4:1 bildet einerseits den Systemträger-Steuerausgang $F_{V3}$ und ist andererseits an den Eingang des Verstärkers E1 angeschlossen. Der Ausgang des Verstärkers E1 bildet den Vormodulationsträgerfrequenzausgang $F_E$, während der Ausgang des Verstärkers E2 an den Eingang b des Modulators M6 geführt ist. Der Ausgang des Frequenzteilers D11 mit einem Teilerverhältnis von 7:1 ist mit dem Eingang des Frequenzteilers D12 mit einem Teilerverhältnis von 3:1 und dem Eingang des Frequenzteilers D13 mit einem Teilerverhältnis von 16:1 verbunden. Der Ausgang des Frequenzteilers D13 mit einem Teilerverhältnis von 16:1 bildet einerseits den Kanalträgerfrequenzausgang $F_{C4}$ und ist andererseits an den Eingang des Filters SZ12 angeschlossen. Der Ausgang des Filters SZ12 bildet den Systemträger-Steuerfrequenzausgang $F_{V1}$. Dem Frequenzteiler D12 mit einem Teilerverhältnis von 3:1 schliessen sich der Eingang des Frequenzteilers D6 mit einem Teilerverhältnis von 32:1 und der Eingang des Frequenzteilers D17 mit einem Teilerverhältnis von 4:1 an. Der Ausgang des Frequenzteilers D6 mit einem Teilerverhältnis von 32:1 ist mit dem Eingang des Verstärkers E4 verbunden, dessen Ausgang mit dem Eingang des Modulators M6 verbunden ist. Der Ausgang des Frequenzteilers D17 mit einem Teilerverhältnis von 4:1 bildet den Systemträger-Steuerfrequenzausgang $F_{V2}$. Der Ausgang des Modulators M6 ist an den Filter SZ6 geführt, dessen Ausgang den Kanalträgerfrequenzausgang $F_{C5}$ bildet.

Nachstehend wird ein Überblick über die Anzahl der in der erfindungsgemässen Schaltungsanordnung gemäss Fig. 6 verwendeten charakteristischen Bauelemente gegeben:

| | |
|---|---|
| Oszillator | 1 |
| Frequenzvervielfacher oder harmonischer Generator | 0 |
| Frequenzteiler | 9 |
| Modulator - Filter | 1 |
| Filter | 1 |
| Verstärker (innerhalb der Kette) | 3 |
| Anzahl der Ausgangsfrequenzen | 7 |

Die erfindungsgemässen Schaltungsanordnungen sind wiederholt aus gleichen Bauelementen aufgebaut. Je System wird jeweils ein Grundoszillator mit Thermostat verwendet, deswegen entspricht die Genauigkeit einer jeden Ausgangsfrequenz der Genauigkeit der Frequenz des Grundoszillators. Die Systemträger-Steuerfrequenzausgänge ermöglichen, dass die Genauigkeit der Systemträgerfrequenzen ebenfalls der Genauigkeit der Frequenz des Grundoszillators entspricht. Die Frequenzteiler können als monolitheintegrierte Schaltungen ausgebildet sein, oder diese Teile der Schaltungen können auch mittels der MSI-Technik ausgeführt werden. Die Verwendung der relativ kleinen Anzahl von Trägerfiltern und Modulatoren beansprucht nur einen kleinen Teil des Montageaufwandes der grossen Anzahl der Kanaleinheiten mit LC-Filter.

Nachstehend wird eine Zusammenfassung der Anzahl der zu den einzelnen Figuren gehörenden Bauelemente und der Ausgangsfrequenzen gegeben:

0186068

| Figur | 1 | 2 | 3 | 4 | 5 | 6 |
|---|---|---|---|---|---|---|
| Oszillator | 1 | 1 | 1 | 1 | 1 | 1 |
| Frequenzvervielfacher oder harmonischer Generator | 1 | 1 | 0 | 0 | 0 | 0 |
| Frequenzteiler | 0 | 0 | 10 | 12 | 13 | 9 |
| Modulator - Filter | 0 | 0 | 10 | 10 | 9 | 1 |
| Filter | 13 | 13 | 0 | 1 | 2 | 1 |
| Verstärker (innerhalb der Kette) | 0 | 0 | 6 | 6 | 8 | 3 |
| Anzahl der Ausgangsfrequenzen | 13 | 13 | 15 | 17 | 15 | 7 |

Die in den Fig. 3 bis 6 dargestellten Lösungen sind Schaltungsanordnungen gemäss der Erfindung. Von besonderer Bedeutung ist z.B. bei der Schaltungsanordnung gemäss Fig. 6, dass zur Erzeugung von sieben Ausgangsfrequenzen nur ein einziger Modulator - Filter und ein gesonderter Filter erforderlich sind. Die in Fig. 6 dargestellte Schaltungsanordnung veranschaulicht die Trägerfrequenzerzeugung für eine 3-kanälige Freileitungsanlage, wobei die auf einen Kanal fallenden Kosten infolge der sonstigen gemeinsamen Schaltungsteile relativ am grössten sind. Aus obigem ist ersichtlich , dass die Erzeugung der Trägerfrequenz bei der erfindungsgemässen Schaltungsanordnung am kostengünstigsten ist.

Patentanprüche

1. Schaltungsanordnung zur Erzeugung von Kanalträgerfrequenzen, und Pilothilfsfrequenzen für vielkanälige Trägerstrom-Fernsprechanlagen mit Vormodulationssystem, die mit einem Grundoszillator, einer andessen Ausgang angeschlossenen Kombination von Frequenzteilern, an den Ausgang der Frequenzteiler angeschlossenen Verstärkern oder an den Ausgang des Frequenzteilers angeschlossenen Filter, desweiteren an den Ausgang der Verstärker angeschlossenen Modulatoren oder sich den Filtern anschliessenden Modulator und an den Ausgang der Filter angeschlossenen Modulatoren sowie Kanalträgerfrequenzausgängen versehen ist, dadurch gekennzeichnet, dass sich dem einzigen Grundoszillator (O) mindestens zwei Frequenzteiler (D1-D10) unmittelbar anschliessen, desweiteren von den Frequenzausgängen der Schaltungsanordnung mindestens fünf Frequenzausgänge ($P_{S1}$, $F_{C2}$, $F_{C6}$, $F_{C10}$, $F_2$) unmittelbar oder über einen Verstärker (E1, E2, E3, E6) an je einen Frequenzteiler (D3, D2, D4, D6, D5, D7, D8) angeschlossen sind.

2. Schaltungsanordnung nach Anspruch 1, dadurch gekennzeichnet, dass an den Ausgang des Grundoszillators (O) zwei Frequenzteiler (D1, D10) angeschlossen sind, von denen der Ausgang des einen Frequenzteilers (D1) mit einen Teilerverhältnis von 20:1 in drei Richtungen verzweigt ist: an den Eingang eines Frequenzteilers (D2) mit einem Teilerverhältnis von 7:1, an den Eingang eines Frequenzteilers (D4) mit einem Teilerverhältnis von 6:1 und an den Eingang eines Frequenzteilers (D8) mit einem Teilerverhältnis von 2:1, während sich der Ausgang des anderen Frequenzteilers (D10) mit einem Teilerverhältnis von 21:1 ebenfalls in drei Richtungen verzweigt: an den Eingang eines Frequenzteilers (D6) mit einem Teilerverhältnis von 32:1, an den Eingang eines Frequenzteilers (D7) mit einem Teilerverhältnis von 5:1 und an den Eingang eines Frequenzteilers (D9) mit einem Tei-

0186068

lerverhältnis von 8:1, dass weiterhin der Ausgang des Frequenzteilers (D2) mit einem Teilerverhältnis von 7:1 an den Eingang des Frequenzteilers (D3) mit einem Teilerverhältnis von 4:1, sowie an den Eingang des Verstärkers (E2) angeschlossen ist, während der Ausgang des Frequenzteilers (D4) mit einem Teilerverhältnis von 6:1 an den Eingang des Frequenzteilers (D5) mit einem Teilerverhältnis von 4:1 und an den Eingang des Verstärkers (E3) angelegt ist, desweiteren der Ausgang des Frequenzteilers (D6) mit einem Teilerverhältnis von 32:1 an den Eingang des Verstärkers (E4), der Frequenzteiler (D7) mit einem Teilerverhältnis von 5:1 an den Eingang des Verstärkers (E6) angeschlossen sind, während der Ausgang des Frequenzteilers (D8) mit einem Teilerverhältnis von 2:1 einen Pilothilfsfrequenzausgang (PS1) bildet und an einen Eingang (b) des Modulators (M10) angeschlossen ist, desweiteren der Ausgang des Frequenzteilers (D9) mit einem Teilerverhältnis von 8:1 an den Eingang des Filters (SZ10) geführt ist, dessen Ausgang an den anderen Eingang (a) des Modulators (M10) angelegt ist, dass dem Ausgang des Modulators (M10) ein Eingang des Filters (SZ11) angeschlossen ist, dessen Ausgang einen Pilothilfsfrequenzausgang (PSZ) bildet, weiterhin der Ausgang des Frequenzteilers (D5) mit einem Teilerverhältnis von 4:1 mit dem Eingang des Verstarkers (E1) verbunden ist, dessen Ausgang sich in vier Richtungen verzweigt: an einen Vormodulationstragerfrequenzausgang ($F_E$), an den Eingang (a) des Modulators (M1), an einen Eingang (a) des Modulators (M4) und einen Eingang (a) des Modulators (M7), dass sich weiterhin der Ausgang des Verstärkers (E2) in vier Richtungen verzweigt: an einen Kanalträgerfrequenzausgang ($F_{C10}$), an einen Eingang (b) des Modulators (M6), an einen Eingang (b) des Modulators (M7) und einen Eingang (b) des Modulators (M8), dass desweiteren der Ausgang des Verstärkers (E3) in vier Richtungen verzweigt ist: an einen Eingang (b) des Modulators (M1), an einen Eingang (b) des Modulators (M2), an einen Kanalträgerfrequenzausgang ($F_{C6}$) und an einen Eingang (b) des Modulators (M9), dass sich weiterhin der Ausgang des Verstärkers (E4) in vier Richtungen verzweigt: an einen Eingang (a) des Modulators (M2), an einen Eingang (a) des Modulators (M5), an einen Eingang (a) des Modulators (M6) und an einen Eingang (a) des Modulators (M9), desweiteren der Ausgang des Verstärkers (E5) einerseits mit dem Eingang (a) des Modulators (M3) und andererseits mit dem Eingang (a) des Modulators (M8) verbunden ist, während sich der Ausgang des Verstärkers (E6) in vier Richtungen verzweigt: an den Eingang (b) des Modulators (M3), an den Eingang (b) des Modulators (M4), an den Eingang (b) des Modulators (M5) und an einen Kanalträgerfrequenzausgang ($F_{C2}$), dass der Ausgang des sich dem Modulator (M1) anschliessenden Filters (SZ1) einen Kanalträgerfrequenzausgang ($F_{C12}$) bildet, während der Ausgang eines sich dem Modulator (M2) anschliessenden Filters (SZ2) einen Kanalträgerfrequenzausgang ($F_{C11}$) bildet, dass weiterhin der Ausgang eines sich dem Modulator (M3) anschliessenden Filters (SZ3) einen Kanalträgerfrequenzausgang ($F_{C9}$) der Ausgang eines sich dem Modulator (M4) anschliessenden Filters (SZ4) einen Kanalträgerfrequenzausgang ($F_{C8}$), der Ausgang eines sich dem Modulator (M5) anschliessenden Filters (SZ5) einen Kanalträgerfrequenzausgang ($F_{C7}$), der Ausgang eines sich dem Modulator (M6) anschliessenden Filters (SZ6) einen Kanalträgerfrequenzausgang ($F_{C5}$), der Ausgang eines sich dem Modulator (M7) anschliessenden Filters (SZ7) einen Kanalträgerfrequenzausgang ($F_{C4}$), der Ausgang eines sich dem Modulator (M8) anschliessenden Filters (SZ8) einen Kanalträgerfrequenzausgang ($F_{C3}$), und der Ausgang eines sich dem Modulator (M9) anschliessenden Filters (SZ9) einen Kanalträgerfrequenzausgang ($F_{C1}$) bilden.

3. Schaltungsanordnung zur Erzeugung von Kanalträgerfrequenzen, Pilothilfsfrequenzen und Systemträger-Steuerfrequenzen für vielkanälige Trägerstrom-Fernsprechanlagen mit Vormodulationssystem, die mit einem Grundoszillator, einer sich dem Ausgang des Grundoszillators anschliessenden Kombination von Frequenzteilern, sich dem Ausgang der Frequenzteiler anschliessenden Verstärkern oder an dem Ausgang der Frequenzteiler angeschlossenen Filtern, an den Ausgang der Verstärker angeschlossenen Modulatoren oder an die Filter angeschlossenen Modulatoren und an den Ausgang der Modulatoren geschalteten Filtern sowie Kanalträgerfrequenzausgängen und Steuerfrequenzausgängen versehen ist, dadurch gekennzeichnet, dass an den einzigen Grundoszillator (O) mindestens zwei Frequenzteiler (D1, D11) unmittelbar angeschlossen sind, dass weiterhin von den zwölf Frequenzausgängen mindestens sieben Frequenzausgänge ($F_E$, $F_{C2}$, $F_{C4}$, $F_{C6}$, $F_{C10}$, $F_{V2}$, $P_{S1}$) unmittelbar oder über einen Verstärker (E1, E2, E3, E6), gegebenenfalls über einen Filter (SZ12) an die Frequenzteiler (D3, D2, D4, D13, D7, D8, D16) angeschlossen sind.

4. Schaltungsanordnung nach Anspruch 3, dadurch gekennzeichnet, dass sich der Ausgang des Grundoszillators (O) in drei Richtungen verzweigt: an einen Systemträger-Steuerfrequenzausgang ($F_{V1}$), an den Eingang des Frequenzteilers (D1) mit einem Teilerverhältnis von 20:1, sowie an den Eingang des Frequenzteilers (D11) mit einem Teilerverhältnis von 7:1, desweiteren der Ausgang des Frequenzteilers (D1) mit einem Teilerverhältnis von 20:1 in drei Richtungen verzweigt ist: an den Eingang des Frequenzteilers (D2) mit einem Teilerverhältnis von 7:1, an den Eingang des Frequenzteilers (D4) mit einem Teilerverhältnis von 6:1 und an den Eingang des Frequenzteilers (D8) mit einem Teilerverhältnis von 2:1, während sich der Ausgang des Frequenzteilers (D11) mit einem Teilerverhältnis von 7:1 in zwei Richtungen verzweigt: an den Eingang des Frequenzteilers (D12) mit einem Teilerverhältnis von 3:1 und an den Eingang des Frequenzteilers (D13) mit einem Teilerverhältnis von 16:1, desweiteren der Ausgang des Frequenzteilers (D12) mit einem Teilerverhältnis von 3:1 mit dem Eingang des Frequenzteilers (D6) mit einem Teilerverhältnis von 32:1,dem Eingang des Frequenzteilers (D7) mit einem Teilerverhältnis von 5:1 und dem Eingang des Frequenzteilers (D9) mit einem Teilerverhältnis von 8:1 verbunden ist, dass weiterhin der Ausgang des Frequenzteilers (D13) mit einem Teilerverhältnis von 16:1 den Kanalträgerfrequenzausgang ($F_{C4}$) bildet und an den Eingang des Filters (SZ12) angelegt ist, dessen Ausgang den Systemträger-Steuerfrequenzausgang ($F_{V2}$) bildet, dass weiterhin der Ausgang des Frequenzteilers (D2) mit einem Teilerverhältnis von 7:1 mit dem Eingang des Verstärkers (E2) und dem Eingang des Frequenzteilers (D3) mit einem Teilerverhältnis von 4:1 verbunden ist, dessen Ausgang an den Eingang des Verstärkers (E1) geführt ist, desweiteren der Ausgang des Frequenzteilers (D4) mit einem Teilerverhältnis von 6:1 an den Eingang des Verstärkers (E3) sowie an den Eingang des Frequenzteilers (D5) mit einem Teilerverhältnis von 4:1 angeschlossen ist, während der Ausgang des Frequenzteilers (D5) mit einem Teilerverhältnis von 4:1 mit dem Eingang des Verstärkers (E5) verbunden ist, dass weiterhin der Ausgang des Frequenzteilers (D6) mit einem Teilerverhältnis von 32:1 mit dem Eingang des Verstärkers (E4) verbunden ist, desweiteren der Ausgang des Frequenzteilers (D7) mit einem Teilerverhältnis von 5:1 an den Eingang des Verstärkers (E6), der Ausgang des Frequenzteilers (D8) mit einem Teilerverhältnis von 2:1 an den Pilothilfsfrequenzausgang ($P_{S1}$) und an den Eingang des Modulators (M10) angeschlossen sind, dass sich weiterhin der Ausgang des Verstärkers (E1) in drei Richtungen verzweigt: an den Vormodulationstragerfrequenzausgang ($F_E$) und an die Eingange (a) der Modulatoren (M1, M4), während der Ausgang des Verstärkers (E2) an den Kanalträgerfrequenzausgang ($F_{C10}$) und an die Eingänge (b) der Modulatoren (M6, M8) angeschlossen ist, desweiteren der Ausgang des Verstärkers (E3) an den Kanalträgerfrequenzausgang ($F_{C6}$), an die Eingänge (b)

der Modulatoren (M1, M2) und an den Eingang (b) des Modulators (M9) geführt ist, während der Ausgang des Verstärkers (E4) mit den Eingängen (a) der Modulatoren (M2, M5, M6, M9) verbunden ist, dass weiterhin der Ausgang des Verstärkers (E5) an dei Eingänge (a) der Modulatoren (M3, M8), der Ausgang des Verstärkers (E6) an die Eingänge (b) der Modulatoren (M3, M4, M5) und an den Kanalträgerfrequenzausgang ($F_{C2}$) angeschlossen sind, desweiteren der Ausgang des Frequenzteilers (D9) mit einem Teilerverhältnis von 8:1 mit dem Eingang des Filters (SZ10) verbunden ist, dessen Ausgang an den Eingang (a) des Modulators (M10) angeschlossen ist, während der Ausgang des sich dem Modulator (M10) anschliessenden Filters (SZ11) den Pilothilfsfrequenzausgang ($P_{SZ}$) bildet, dass weiterhin der Ausgang des sich dem Modulator (M1) anschliessenden Filters (SZ1) den Kanalträgerfrequenzausgang ($F_{C12}$), der Ausgang des sich dem Modulator (M2) anschliessenden Filters (SZ2) den Kanalträgerfrequenzausgang ($F_{C11}$), der Ausgang des sich dem Modulator (M3) anschliessenden Filters (SZ3) den Kanalträgerfrequenzausgang ($F_{C9}$), der Ausgang des sich dem Modulator (M4) anschliessenden Filters (SZ4) den Kanalträgerfrequenzausgang ($F_{C8}$), der Ausgang des sich dem Modulator (M5) anschliessenden Filters (SZ5) den Kanalträgerfrequenzausgang ($F_{C7}$), der Ausgang des sich dem Modulator (M6) anschliessenden Filters (SZ6) den Kanalträgerfrequenzausgang ($F_{C5}$) der Ausgang des sich dem Modulator (M8) anschliessenden Filters (SZ8) den Kanalträgerfrequenzausgang ($F_{C3}$) und der Ausgang des sich dem Modulator (M9) anschliessenden Filters (SZ9) den Kanalträgerfrequenzausgang ($F_{C1}$) bilden.

5. Schaltungsanordnung zur Erzeugung von Kanalträgerfrequenzen, Systemträger-Steuerfrequenzen und Systemträgerfrequenzen für vielkanälige Trägerstrom-Fernsprechanlagen mit Vormodulationssystem, die mit einem Grundoszillator, einem an dessen Ausgang angeschlossenen Verstärker oder an die Ausgänge der Frequenzteiler angeschlossenen Filtern, an

- 25 -                    0186068

die Ausgänge der Verstärker angeschlossenen Modulatoren
oder an die Modulatoren angeschlossenen Filtern versehen ist, dadurch gekennzeichnet, dass an den einzigen
Grundoszillator (O) mindestens zwei Frequenzteiler (D1, D11)
unmittelbar angeschlossen sind, dass weiterhin von fünfzehn abgehenden Frequenzausgängen (Fe, $Fe_2$, $F_{C4}$, $F_{C10}$, $F_{V1}$)
mindestens sechs Frequenzausgänge unmittelbar über einen
Verstärker an den Ausgang von Frequenzteilern (D3, D7, D13,
D4, D2, D14) angeschlossen sind.

6. Schaltungsanordnung nach Anspruch 5, dadurch gekennzeichnet, dass sich der Ausgang des Grundoszillators
(O) in zwei Richtungen verzweigt: an den Eingang des Frequenzteilers (D1) mit einem Teilerverhältnis von 20:1 und
an den Eingang des Frequenzteilers (D10) mit einem Teilerverhältnis von 7:1, dass der Ausgang des Frequenzteilers
(D1) mit einem Teilerverhältnis von 20:1 mit dem Eingang
des Frequenzteilers (D2) mit einem Teilerverhältnis von
7:1 und dem Eingang des Frequenzteilers (D4) mit einem
Teilerverhältnis von 6:1 verbunden ist, während der Frequenzteiler (D11) mit einem Teilerverhältnis von 7:1 mit
dem Eingang des Frequenzteilers (D13) mit einem Teilerverhältnis von 16:1 und dem Eingang des Frequenzteilers
(D12) mit einem Teilerverhältnis von 3:1 verbunden ist,
dessen Ausgang an den Eingang des Frequenzteilers (D6)
mit einem Teilerverhältnis von 32:1 und an den Eingang
des Frequenzteilers (D7) mit einem Teilerverhältnis von
5:1 geführt ist, dass weiterhin der Ausgang des Frequenzteilers (D13) mit einem Teilerverhältnis von 16:1 einerseits an den Kanalträgerfrequenzausgang ($F_{C4}$) und andererseits an den Eingang des Frequenzteilers (D14) mit
einem Teilerverhältnis von 2:1 angeschlossen ist, dessen
Ausgang mit dem Eingang des Verstärkers (E8) verbunden
ist, wobei der Ausgang des Verstärkers (E8) einerseits
den Systemträger-Steuerfrequenzausgang ($F_{V1}$) bildet und
andererseits an den Eingang des Frequenzteilers (D15) mit einem Teilerverhältnis von 2:1 und an den Eingang des Frequenzteilers (D16) mit einem Teilerverhältnis von 5:1 geführt ist, desweiteren der Ausgang des Frequenzteilers (D2) mit einem Teilerverhältnis von 7:1 an den Eingang des Frequenzteilers (D3) mit einem Teilerverhältnis von 4:1 und an den Eingang des Verstärkers (E2) angeschlossen ist, während der Ausgang des Frequenzteilers (D3) mit einem Teilerverhältnis von 4:1 mit dem Eingang des Verstärkers (E1) verbunden ist, dass weiterhin der Ausgang des Frequenzteilers (D4) mit einem Teilerverhältnis von 6:1 an den Eingang des Frequenzteilers (D5) mit einem Teilerverhältnis von 4:1 sowie an den Eingang des Verstärkers (E3) angeschlossen ist, desweiteren der Ausgang des Frequenzteilers (D5) mit einem Teilerverhältnis von 4:1 mit dem Eingang des Verstärkers (E5) verbunden ist, während der Ausgang des Frequenzteilers (D7) mit einem Teilerverhältnis von 5:1 an den Eingang des Verstärkers (E6) angelegt ist, dass weiterhin der Ausgang des Frequenzteilers (D15) mit einem Teilerverhältnis von 2:1 mit dem Eingang des Filters (SZ13) verbunden ist, dessen Ausgang an den Eingang (a) des Modulators (M11) angeschlossen ist, während der Ausgang des Modulators (M11) mit dem Filter (SZ14) verbunden ist, desweiteren der Ausgang des Frequenzteilers (D16) mit einem Teilerverhältnis von 5:1 an den Eingang des Filters (SZ15) geführt ist, dessen Ausgang mit dem Eingang des Verstärkers (E7) verbunden ist, während der Ausgang des Verstärkers (E7) an den Eingang (b) des Modulators (M11) geführt ist, wobei der Ausgang des Filters (SZ14) den Systemträgerausgang ($F_{FR}$) bildet, dass weiterhin der Ausgang des Verstärkers (E1) an den Vormodulationstragerfrequenzausgang ($F_E$) und an den Eingang (a) des Modulators (M1) sowie den Eingang (a) des Modulators (M4) angeschlossen ist, dass der Ausgang des Verstärkers (E2) an den Kanalträgerfrequenzausgang ($F_{C10}$) und an die Eingänge (b) der Modulatoren (M6, M8), der Ausgang des Verstärkers (E3) an die Eingänge (b) der Modulatoren (M1, M2, M4) und an den Kanalträgerfrequenzausgang ($F_{C6}$), der Ausgang des Verstärkers (E4) an die Eingänge (a) der Modulatoren (M2, M5, M6, M9), der Ausgang des Verstärkers (E5) an die Eingänge (a) der Modulatoren (M3, M8), der Ausgang des Verstärkers (E6) an die Eingänge (b) der Modulatoren (M3, M4, M5) und an den Kanalträgerfrequenzausgang ($F_{C2}$) angeschlossen sind, dass weiterhin der Ausgang des sich dem Modulator (M1) anschliessenden Filters (SZ1) den Kanalträgerfrequenzausgang ($F_{C12}$), der Ausgang des sich dem Modulator (M2) anschliessenden Filters (SZ2) den Kanalträgerfrequenzausgang ($F_{C11}$), der Ausgang des sich dem Modulator M3) anschliessenden Filters (SZ3) den Kanalträgerfrequenzausgang ($F_{C9}$), der Ausgang des sich dem Modulator (M4) anschliessenden Filters (SZ4) den Kanalträgerfrequenzausgang ($F_{C8}$), der Ausgang des sich dem Modulator (M5) anschliessenden Filters (SZ5) den Kanalträgerfrequenzausgang ($F_{C7}$), der Ausgang des sich dem Modulator (M6) anschliessenden Filters (SZ6) den Kanalträgerfrequenzausgang ($F_{C5}$), der Ausgang des sich dem Modulator (M8) anschliessenden Filters (SZ8) den Kanalträgerfrequenzausgang ($F_{C3}$) und der Ausgang des sich dem Modulator (M9) anschliessenden Filters (SZ9) den Kanalträgerfrequenzausgang ($F_{C1}$) bilden.

7. Schaltungsanordnung zur Erzeugung von Kanalträgerfrequenzen, und Systemträger-Steuerfrequenzen für vielkanälige Trägerstrom-Fernsprechanlagen mit Vormodulationssystem, die mit einem Grundoszillator, einer sich dem Ausgang des Grundoszillators anschliessenden Kombination von Frequenzteilern, sich dem Ausgang der Frequenzteiler anschliessenden Verstärkern oder einem sich dem Ausgang des Frequenzteilers (D16) anschliessenden Filter, an den Ausgang der Verstärker angeschlossenen Modulator und an den Ausgang angeschlossenen Filter versehen ist, dadurch gekennzeichnet, dass an den Grundoszillator (O) mindestens zwei Fre-

- 28 -                                          0186068

quenzteilers (D1, D11) unmittelbar angeschlossen sind, desweiteren von sieben abgehenden Frequenzausgängen mindestens sechs Ausgänge (Fe, $F_{C4}$, $F_{C6}$, $F_{V1}$, $F_{V2}$, $F_{V3}$) über einen Verstärker (E1) oder Filter (SZ12) unmittelbar an den Ausgang des Frequenzteilers angeschlossen sind.

8. Schaltungsanordnung nach Anspruch 7, dadurch gekennzeichnet, dass der Ausgang des Grundoszillators (O) an den Eingang des Frequenzteilers (D1) mit einem Teilerverhältnis von 20:1 und an den Eingang des Frequenzteilers (D11) mit einem Teilerverhältnis von 7:1 angeschlossen ist, desweiteren der Ausgang des Frequenzteilers (D1) mit einem Teilerverhältnis von 20:1 mit dem Eingang des Frequenzteilers (D4) mit einem Teilerverhältnis von 6:1 und mit dem Eingang des Frequenzteilers (D2) mit einem Teilerverhältnis von 7:1 verbunden ist, während der Ausgang des Frequenzteilers(D4) mit einem Teilerverhältnis von 6:1 den Kanalträgerfrequenzausgang ($F_{C6}$) bildet, dass weiterhin der Ausgang des Frequenzteilers (D2) mit einem Teilerverhältnis von 7:1 an den Eingang des Verstärkers (E2) und an den Eingang des Frequenzteilers (D3) mit einem Teilerverhältnis von 4:1 angeschlossen ist, dessen Ausgang einerseits an den Systemträger-Steuerfrequenzausgang ($F_{V3}$) und andererseits an den Eingang des Verstärkers (E1) geführt ist, dessen Ausgang den Vormodulationsträgerfrequenzausgang ($F_E$) bildet, desweiteren der Ausgang des Verstärkers (E2) an den Eingang (b) des Modulators (M6) geführt ist, während der Ausgang des Frequenzteilers (D11) mit einem Teilerverhältnis von 7:1 an den Eingang des Frequenzteilers (D12) mit einem Teilerverhältnis von 3:1 und an den Eingang des Frequenzteilers (D13) mit einem Teilerverhältnis von 16:1 angeschlossen ist, dessen Ausgang einerseits an den Kanalträgerfrequenzausgang ($F_{C4}$) und andererseits an den Eingang des Filters (SZ12) angelegt ist, dessen Ausgang den Systemträger-Steuerfrequenzausgang ($F_{V1}$) bildet, dass sich weiterhin dem Ausgang des Frequenzteilers (D12) mit einem Teilerverhältnis von 3:1 der Eingang des Frequenzteilers (D6) mit einem Teilerverhältnis von 32:1 und der Eingang des Frequenzteilers (D17) mit einem Teilerverhältnis von 4:1 anschliessen, während der Ausgang des Frequenzteilers (D16) mit einem Teilerverhältnis von 32:1 an den Eingang des Verstärkers (E4) angeschlossen ist, dessen Ausgang an den Eingang (a) des Modulators (M6) geführt ist, dass weiterhin der Ausgang des Frequenzteilers (D17) den Systemträger-Steuerfrequenzausgang ($F_{V2}$) bildet, desweiteren der Ausgang des Modulators (M6) an den Eingang des Filters (SZ6) angeschlossen ist, wobei der Ausgang des Filters (SZ6) den Kanalträgerfrequenzausgang ($F_{C5}$) bildet.

Fig. 1

Fig. 2

Fig. 3

0186068

Fig. 4

Fig. 5

Fig. 6

Europäisches
Patentamt

## EUROPÄISCHER RECHERCHENBERICHT

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| Y | ELECTRONIC ENGINEERING, Band 33, nr. 404, Oktober 1961, Seiten 646-649, London, GB; G.F. NEWELL et al.: "A fourier transform generator" * Seite 646, linke Spalte, Zeile 1 - rechte Spalte, Zeile 32; Figur 7 * | 1,3,5, 7 | H 04 J   1/06 |
| A | Idem | 2,4,6, 8 | |
| | --- | | |
| Y | ERICSSON REVIEW, Band 52, Nr. 3/4, 1975, Seiten 106-115, Stockholm, SE; R. ASARNOJ et al.: "Channel translating equipment in the M5 construction practice" * Seite 112, linke Spalte, Zeile 20 - rechte Spalte, Zeile 21; Figur 15 * | 1,3,5, 7 | RECHERCHIERTE SACHGEBIETE (Int Cl 4) |
| A | Idem | 2,4,6, 8 | H 04 J<br>H 03 B |
| | --- | | |
| A | DE-B-1 297 157  (SIEMENS AG) * Spalte 1, Zeilen 18-27; Spalte 3, Zeile 67 - Spalte 4, Zeile 46; Figur * | 1,3,5, 7 | |
| | ---          -/- | | |

Der vorliegende Recherchenbericht wurde für alle Patentansprüche erstellt

| Recherchenort<br>DEN HAAG | Abschlußdatum der Recherche<br>04-03-1986 | Prüfer<br>BALBINOT H. |
|---|---|---|

KATEGORIE DER GENANNTEN DOKUMENTE
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82

Europäisches
Patentamt

EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| A | HASLER-MITTEILUNGEN, Band 33, Nr. 2, 1974, Bern, CH, K. NIEDERHAUSER: "Träger-, Pilot- und Signalfrequenzerzeugung BW 72" * Seite 61, linke Spalte, Zeile 1 - Seite 62, linke Spalte, Zeile 13; Figuren 1,13 * | 1,3,5, 7 | |
| A | CABLES AND TRANSMISSION, Band 29, Nr. 3, Juli 1975, Seiten 314-328, Paris, FR; J.-C. DUVAL: "Equipement de production d'ondes porteuses et pilote pour matériel à douze voies, à prémodulation à 24 kHz, avec possibilité de transfert sur organes de secours" * Seite 315, Zeile 45 - Seite 316, Zeile 7; Figur 1 * | 1,3,5, 7 | |

RECHERCHIERTE
SACHGEBIETE (Int. Cl.4)

Der vorliegende Recherchenbericht wurde für alle Patentansprüche erstellt.

| Recherchenort DEN HAAG | Abschlußdatum der Recherche 04-03-1986 | Prüfer BALBINOT H. |
|---|---|---|